# EUROPEAN PATENT APPLICATION

(11) **EP 4 439 637 A1**
(43) Date of publication of application: **02.10.2024**
(21) Application number: 22897647.8
(22) Date of filing: 15.11.2022
(51) Int. Cl.: H01L 21/683, H01L 21/3065, H01J 37/20, H01J 37/305

(54) **ELECTROSTATIC TRAY AND BASE**

(30) Priority: 26.11.2021 CN 202111419897
(71) Applicant: Beijing NAURA Microelectronics Equipment Co., Ltd., Beijing 100176 (CN)
(72) Inventor: RONG, Yantian, Beijing 100176 (CN)
(74) Representative: LifeTech IP Spies & Behrndt Patentanwälte PartG mbB
(86) International application number: PCT/CN2022/131858
(87) International publication number: WO 2023/093564

(57) **Abstract**

The present disclosure provides an electrostatic chuck and a base. The electrostatic chuck includes a chuck body, a voltage feed member, and a plurality of absorption members. The plurality of absorption members are arranged at the chuck body at intervals. Each absorption member includes an insulation layer, an electrode layer, and a dielectric layer arranged sequentially in a direction away from the chuck body. The voltage feed member is arranged between the absorption member and the chuck body and electrically contacts the electrode layers of the plurality of absorption members. The voltage feed member is configured to feed the DC voltage to the electrode layer of each absorption member. The plurality of wafers can be absorbed by the plurality of absorption members in a one-to-one correspondence. With the electrostatic chuck and the base of the present disclosure, the manufacturing difficulty and cost of the multi-wafer electrostatic chuck can be reduced, and the RF coupling efficiency and the semiconductor processing efficiency can be improved.

## Description

### TECHNICAL FIELD

The present disclosure generally relates to the semiconductor equipment technology field and, more particularly, to an electrostatic chuck and a base.

### BACKGROUND

In recent years, with the development of the mini LED and micro LED markets, a traditional multi-wafer mechanical chuck applied for LED no longer satisfies the market requirement for wafer edge utilization rate and uniformity. Since an electrostatic chuck (ESC) absorbs the wafer through a Coulomb force (i.e., an electrostatic force), a cover applied by the mechanical chuck is not needed to compress the wafer. Thus, the wafer edge is exposed in the semiconductor processing environment, which improves the wafer edge utilization rate and uniformity. Therefore, for the multi-wafer LED, a multi-wafer electrostatic chuck is provided. The multi-wafer electrostatic chuck provides a plurality of wafer carrier positions and effectively solves the problem of poor uniformity between wafers, poor uniformity within a wafer, and low edge utilization rate. Thus, the machine becomes more competitive.

The existing multi-wafer electrostatic chuck includes a sintered ceramic base and a dielectric layer, an electrode layer, and an insulation layer sintered from top to bottom in the base. In the semiconductor process, a direct current (DC) voltage is fed into the electrode layer to generate a Coulomb force between the electrode layer and the plurality of wafers to absorb the plurality of wafers at the dielectric layer. Radiofrequency (RF) is coupled to the electrode layer to attract plasma to bombard and etch the wafer. By considering the structural strength of the multi-wafer electrostatic chuck, the insulation layer in the base includes ceramic, and the thickness of the insulation layer needs to be increased (e.g., 1.5mm to 2mm). Meanwhile, to ensure the RF smoothly passes through the insulation layer and the dielectric layer to attract the plasma, the electrode layer includes a plurality of layer structures arranged at intervals in a direction from the insulation layer to the dielectric layer. Thus, the RF is gradually coupled to a layer structure close to the dielectric layer from a layer structure close to the insulation layer through a plurality of layer structures. Moreover, the electrode layer further needs to include an electrical connection structure configured to electrically connect the plurality of layer structures to cause the DC voltage to be fed into the layer structure close to the dielectric layer through the plurality of layer structures.

However, the more the layer structures of the electrode layer are, the more difficult the sintering process of the electrical connection structure is, and the higher the cost is. In addition, since the insulation layer is thick, the RF coupling efficiency is greatly affected, and the etching rate is affected.

### SUMMARY

The present disclosure is intended to solve one of the technical problems in the existing technology and provides an electrostatic chuck and a base, which can reduce the manufacturing difficulty and the cost of the multi-wafer electrostatic chuck and improve the RF coupling efficiency and the semiconductor processing efficiency.

To realize the above purpose, the present disclosure provides an electrostatic chuck configured to absorb a plurality of wafers. The electrostatic chuck includes a chuck body, a voltage feed member, and a plurality of absorption members.

The plurality of adsorption members are arranged at the chuck body at intervals. Each absorption member of the plurality of absorption members includes an insulation layer, an electrode layer, and a dielectric layer arranged sequentially in a direction away from the chuck body.

The voltage feed member is arranged between the adsorption members and the chuck body and is electrically connected to electrode layers of the plurality of adsorption members. The voltage feed member is configured to feed direct current (DC) voltage into the electrode layer of each adsorption member of the plurality of absorption members to allow the plurality of absorption members to absorb the plurality of wafers in a one-to-one correspondence.

In some embodiments, the electrostatic chuck further includes a positioning member. The positioning member is arranged at the chuck body and includes a plurality of positioning through-holes arranged at intervals. The plurality of absorption members are arranged in the plurality of positioning through-holes in a one-to-one correspondence.

In some embodiments, through-holes are formed at the insulation layers of the absorption members. The through-holes pass through the insulation layers to the electrode layers. The voltage feed member includes a wire structure. The wire structure includes an introduction end and a feed end. The introduction end is configured to be electrically connected to the DC power source. A quantity of feed ends is the same as a quantity of the absorption members. The feed ends are electrically connected to the electrode layers via the through-holes.

In some embodiments, the wire structure includes an introduction wire, a plurality of feed wires, and a ring-shaped wire with an opening. One end of the introduction wire is electrically connected to the ring-shaped wire, and the other end of the introduction wire is used as the introduction end. The plurality of feed wires are arranged along a circumference of the ring-shaped wire at intervals. One end of each feed wire of the plurality of feed wires is electrically connected to the ring-shaped wire, and the other end of each feed wire of the plurality of feed wires are used as the feed end.

In some embodiments, the voltage feed member further includes an insulation sleeve and a plurality of elastic conductive elements. The insulation sleeve is sleeved at an outer side of the introduction wire, the plurality of feed wires, and the ring-shaped wire. The plurality of elastic conductive elements are arranged at the plurality of feed ends in a one-to-one correspondence, and the plurality of elastic conductive elements electrically contact the electrode layers of the plurality of absorption members in a one-to-one correspondence.

In some embodiments, the chuck body includes a first groove and an introduction channel. A shape of the first groove matches a shape of the voltage feed member. The voltage feed member is embedded in the first groove. The introduction channel communicates with the first groove, passes through the chuck body, and is configured for the introduction end to be electrically connected to the DC power source.

In some embodiments, the chuck body includes a plurality of second grooves arranged at intervals. The plurality of second grooves communicate with a part of the first groove embedded with the feed end. Shapes of the second grooves match shapes of the absorption members. The plurality of absorption members are arranged in the plurality of second grooves in a one-to-one correspondence.

In some embodiments, the adsorption members are adhered to the second grooves.

In some embodiments, a thickness of the insulation layer is greater than or equal to 0.6 mm and smaller than or equal to 0.8 mm. A thickness of the electrode layer is greater than or equal to 0.03 mm and smaller than or equal to 0.04 mm. A thickness of the dielectric layer is greater than or equal to 0.25 mm and smaller than or equal to 0.35 mm.

In some embodiments, a material of the insulation layer includes ceramic, and a material of the chuck body includes metal.

The present disclosure further provides a base, including a chuck and the electrostatic chuck of the present disclosure. The electrostatic chuck is arranged on the chuck and configured to absorb the plurality of wafers.

In some embodiments, the base further includes an electrical feed assembly and an RF feed assembly. The electrical feed assembly is electrically connected to the voltage feed member. The electrical feed assembly is configured to be electrically connected to the DC power source and feed the DC voltage provided by the DC power source to the voltage feed member. The RF feed assembly is electrically connected to the chuck and configured to feed RF to the electrostatic chuck through the chuck.

The present disclosure includes the following beneficial effects.

In the electrostatic chuck of the present disclosure, by designing the chuck body, the voltage feed member, the positioning member, and the plurality of absorption members that are independent of each other, arranging the plurality of absorption members in the plurality of positioning through-holes, and arranging the voltage feed member between the absorption member and the chuck body, the chuck body can be configured to carry the voltage feed member and the plurality of absorption members. Thus, the structural strength of the electrostatic chuck can be ensured without depending on the absorption members configured to absorb the plurality of wafers. Through such design, the insulation layer of the absorption member may not need to be designed to be thick to ensure the structural strength of the electrostatic chuck. That is, the insulation layer in the absorption member of the electrostatic chuck of the present disclosure can be designed to be thinner than the insulation layer of the existing multi-wafer electrostatic chuck. Thus, the RF can more easily pass through the insulation layer and the dielectric layer of the absorption member to attract the plasma to further avoid the RF energy loss and improve the RF coupling efficiency. In addition, the electrode layers of the plurality of absorption members of the electrostatic chuck of the present disclosure are within the same layer, the DC voltage can be fed to the electrode layer of each adsorption member only through the voltage feed member instead of designing the electrical connection structure configured to electrically connect the plurality of electrode layers and arranged between the plurality of electrode layers at different layers in the existing technology. With the technical solution of the present disclosure, the manufacturing difficulty and cost of the multi-wafer electrostatic chuck can be reduced. Thus, the multi-wafer electrostatic chuck can be manufactured, the RF coupling efficiency and the etching rate can be improved, and the semiconductor processing efficiency can be further increased.

In the base of the present disclosure, by arranging the electrostatic chuck of the present disclosure at the chuck, the plurality of wafers can be absorbed by the electrostatic chuck of the present disclosure to reduce the manufacturing difficulty and cost of the multi-wafer electrostatic chuck. Thus, the multi-wafer electrostatic chuck can be manufactured, the RF coupling efficiency can be improved, and the semiconductor processing efficiency can be further increased.

### BRIEF DESCRIPTION OF THE DRAWINGS

FIG. 1 illustrates a schematic exploded structural diagram of an electrostatic chuck according to some embodiments of the present disclosure.
FIG. 2 illustrates a schematic local cross-section perspective structural diagram of an electrostatic chuck according to some embodiments of the present disclosure.
FIG. 3 illustrates a schematic local cross-section top view structural diagram of an electrostatic chuck according to some embodiments of the present disclosure.
FIG. 4 illustrates a schematic front structural diagram of an absorption member of an electrostatic chuck according to some embodiments of the present disclosure.
FIG. 5 illustrates a schematic side view cross-section structural diagram of an absorption member of an electrostatic chuck according to some embodiments of the present disclosure.
FIG. 6 illustrates a schematic front structural diagram of a voltage feed member of an electrostatic chuck according to some embodiments of the present disclosure.
FIG. 7 illustrates a schematic perspective structural diagram of a voltage feed member of an electrostatic chuck according to a second embodiment of the present disclosure.
FIG. 8 illustrates a schematic front structural diagram of a chuck body of an electrostatic chuck according to some embodiments of the present disclosure.
FIG. 9 illustrates a schematic structural diagram of a base according to some embodiments of the present disclosure.

### DETAILED DESCRIPTION OF THE EMBODIMENTS

To help those skilled in the art better understand the technical solutions of the present disclosure, the electrostatic chuck and the base of the present disclosure are described in detail in connection with the accompanying drawings.

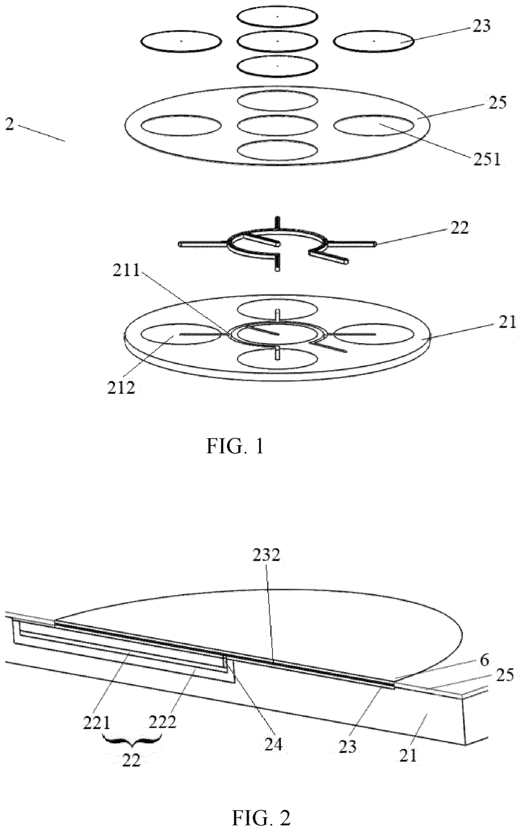

As shown in FIGs. 1 to 5, embodiments of the present disclosure provide an electrostatic chuck 2 configured to adsorb a plurality of wafers 6. The electrostatic chuck 2 includes a chuck body 21, a voltage feed member 22, and a plurality of adsorption members 23. The plurality of adsorption members 23 are arranged at the shuck body 21. In some embodiments, the electrostatic chuck 2 further includes a positioning member 25. The material of the positioning member 25 can include quartz or other insulation and high-temperature-resistant materials. The positioning member 25 is arranged at the chuck body 21. A plurality of positioning through-holes 251 are formed at the positioning member 25 at intervals. The plurality of absorption members 23 are arranged in the plurality of positioning through-holes 251 in a one-to-one correspondence. with the positioning member 25, and the plurality of positioning through-holes 251 formed at the positioning member 25 at intervals, the plurality of absorption members 23 can be positioned, the plurality of wafers 6 can be placed in the plurality of positioning through-holes 251 in a one-to-one correspondence when the plurality of absorption members 23 are in the one-to-one correspondence with the plurality of positioning through-holes 251. Thus, the plurality of wafers 6 in the one-to-one correspondence with the plurality of positioning through-holes 251 can be positioned, which prevents the plurality of wafers 6 from moving in the semiconductor process to improve the application stability of the electrostatic chuck 2 and the semiconductor process stability. In practical applications, any other structures can also be used to position the absorption members 23, or the plurality of absorption members 23 can be directly fixed at the chuck body 21 in an adhesive manner. In addition, other structures can also be used to position the wafers 6 of the absorption members 23, which is not limited in embodiments of the present disclosure.

Each absorption member 23 includes an insulation layer 231, an electrode layer 232, and a dielectric layer 233 arranged sequentially in a direction away from the chuck body 21. The voltage feed member 22 is arranged between the absorption member 23 and the chuck body 21 and electrically connected to the electrode layer 232 of the plurality of absorption members 23. The voltage feed member 22 can be configured to feed a DC voltage to the electrode layer 232 of each absorption member 23. Thus, the plurality of wafers 6 can be absorbed by the plurality of absorption members 23 in a one-to-one correspondence.

In the electrostatic chuck 2 of embodiments of the present disclosure, by providing the chuck body 21, the voltage feed member 22, the positioning member 25, and the plurality of absorption members 23 that are independent of each other, arranging the plurality of absorption members 23 in the plurality of positioning through-holes 251 of the positioning member 25, and arranging the voltage feed member 22 between the absorption member 23 and the chuck body 21, the chuck body 21 can be configured to carry the voltage feed member 22 and the plurality of absorption members 23. Thus, the structural strength of the electrostatic chuck 2 can be ensured by the chuck body 21 instead of the absorption member 23 configured to absorb the plurality of wafers 6. Through this design, the insulation layer 231 of the absorption member 23 may no longer need to be designed to be thick to ensure the structural strength of the electrostatic chuck 2. That is, the insulation layer 231 in the absorption member 23 of the electrostatic chuck 2 of embodiments of the present disclosure can be designed to be thinner than the insulation layer 231 of the existing multi-wafer electrostatic chuck 2. Thus, the RF can pass through the insulation layer 231 and the dielectric layer 233 more easily to attract the plasma to further avoid RF energy loss and improve the RF coupling efficiency. In addition, the plurality of absorption members 23 of the electrostatic chuck 2 of embodiments of the present disclosure are arranged at the chuck body 21. Thus, the electrode layers 23 of the plurality of absorption members 23 can be in a same layer. The DC voltage can only be fed to the electrode layer 232 of each absorption member 23 only through the voltage feed member 22 instead of designing an electrical connection structure configured to electrically connect the plurality of electrode layers between the plurality of electrode layers at different layers as the existing technology. Through the technical solution of embodiments of the present disclosure, the processing difficulty and the cost of the plurality of electrostatic chuck 2 can be lowered. Thus, the multi-wafer electrostatic chuck 2 can be manufactured, the RF coupling efficiency can be improved, and the etching rate can be increased to improve the semiconductor process efficiency.

In semiconductor processes, the voltage feed member 22 can feed direct current (DC) voltage to the electrode layers 232 of the adsorption member 23 to cause the electrode layers 232 of the absorption member 23 and the plurality of wafers 6 to become polarized with positive and negative opposite charges in the one-to-one correspondence to generate the Coulombic forces between the adsorption members 23 and the corresponding wafers 6 to allow the adsorption members 23 to adsorb the wafers 6 in the one-to-one correspondence. Therefore, the electrostatic chuck 2 of embodiments of the present disclosure can absorb and carry the plurality of wafers 6.

During the semiconductor processes, RF can be coupled to the electrode layers 232 of the plurality of absorption members 23 to attract the plasma to bombard the plurality of wafers absorbed at the plurality of absorption members 23 to etch the plurality of wafers 6.

With the electrostatic chuck 2 of embodiments of the present disclosure, the thickness of the insulation layer 231 can be greater than or equal to 0.6 mm and smaller than or equal to 0.8 mm, which is thinner than the thickness of 1.5 mm to 2 mm of the insulation layer in the existing multi-wafer electrostatic chuck. Thus, RF loss can be reduced when passing the insulation layer 231 to improve the RF coupling efficiency and semiconductor processing efficiency.

In some embodiments of the present disclosure, the thickness of the insulation layer 231 can be 0.67 mm.

In some embodiments, the thickness of the electrode layer 232 can be greater than or equal to 0.03 mm and smaller than or equal to 0.04 mm.

In some embodiments, the thickness of the dielectric layer 233 can be greater than or equal to 0.25 mm and smaller than or equal to 0.35 mm.

In some embodiments, the thickness of the electrode layer 232 can be 0.03 mm.

In some embodiments, the thickness of the dielectric layer 233 can be 0.3 mm.

In some embodiments, the material of the chuck body 21 can include metal. Metal is a conductor, and RF needs to pass through the chuck body 21 to be coupled to the electrode layers 232 of the absorption members 23. Thus, while ensuring the structural strength of the electrostatic chuck, the loss of the RF passing through the chuck body 21 can be reduced or even avoided to improve the RF coupling efficiency and semiconductor processing efficiency.

In some embodiments, the material of the chuck body 21 can include aluminum.

In some embodiments, the material of the insulation layer 231 can include ceramic.

In some embodiments, the material of the dielectric layer 233 can also include ceramic.

In some embodiments, the dielectric layer 233, electrode layer 232, and insulation layer 231 of the adsorption member 23 can be formed by a sintering process.

As shown in FIG. 2, FIG. 3, and FIG. 5, in some embodiments, the insulation layers 231 of the adsorption members 23 can include through-holes 234. The through-holes 234 pass through the insulation layers 231 to the electrode layers 232. The voltage feed member 22 includes a wire structure 221. The wire structure 221 can include an introduction end and a feed end. The introduction end can be configured to be electrically connected to the DC power source (not shown in the figure). The quantity of the feed ends can be the same as the quantity of the absorption members 23. The feed end can be electrically connected to the electrode layer 232 via the through-hole 234. The feed end can be configured to feed the DC voltage that is introduced through the introduction end into the electrode layer 232.

That is, the wire structure 221 can include the introduction end and the feed ends with the same quantity as the absorption members 23. The introduction end can be electrically connected to the DC power source and can feed the DC voltage of the DC power source to the wire structure 221. That is, the DC voltage of the DC power source can be fed to the wire structure 221 via the introduction end. The feed ends can pass through the through-holes 234 of the plurality of absorption members 23 in a one-to-one correspondence. Since the through-holes 234 pass through the absorption members 23 to the electrode layers 232, the feed ends can pass through the through-holes 234 of the plurality absorption members 23 in the one-to-one correspondence and can be electrically connected to the electrode layers 232 of the plurality of absorption members 23 in the one-to-one correspondence. The DC voltage fed to the wire structure 221 can be fed into the electrode layers 232 of the plurality absorption members 23 via the feed ends in the one-to-one correspondence.

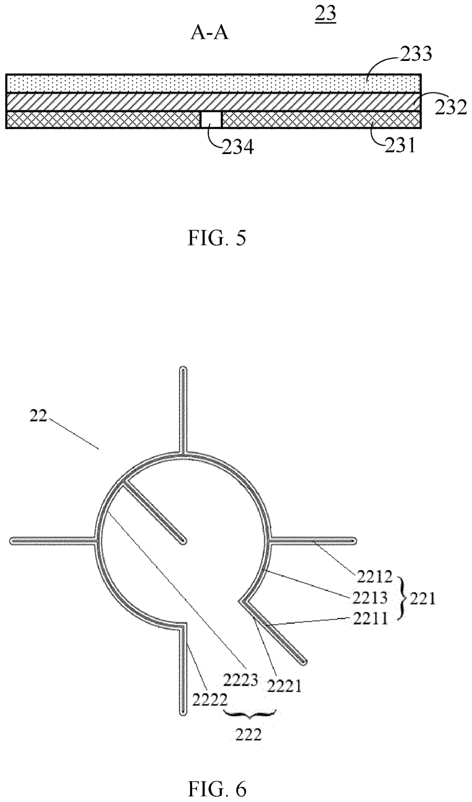

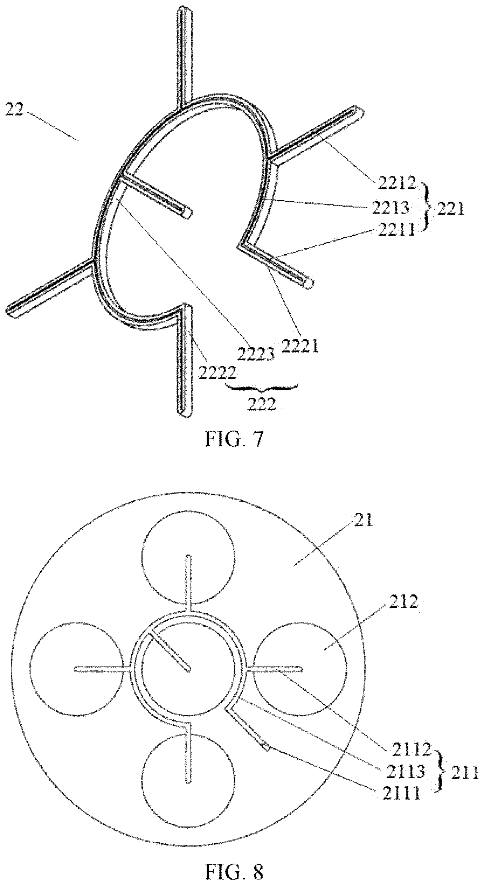

As shown in FIG. 6 and FIG. 7, in some embodiments, the wire structure 221 includes an introduction wire 2211, a plurality of feed wires 2212, and a ring wire 2213 with an opening. An end of the introduction wire 2211 is electrically connected to the ring wire 2213. The other end of the introduction wire 2211 is used as the introduction end. The plurality of feed wires 2213 are arranged along the circumference of the ring wire 2213 at intervals. An end of each of the feed wires 2212 can be electrically connected to the ring wire 2213. The other end of each of the feed wires 2212 can be used as a feed end. In some embodiments, as shown in FIG. 1, five absorption members 23 are provided. One absorption member 23 of the five absorption members 23 is at a center position of the chuck body 21, the remaining four absorption members 23 are arranged along the circumference of the chuck body 21 symmetrically around the absorption member 23 at the center position. Thus, correspondingly, five feed wires 2212 are provided. One feed wire 2212 of the five feed wires 2212 is at an inner side of the ring wire 2213 and is electrically connected to the electrode layer 232 of the absorption member 23 at the center position. The remaining four feed wires 2212 are at an outer side of the ring wire 2213 and are electrically connected to the electrode layers 232 of the four absorption members 23 in the one-to-one correspondence. In some embodiments, the introduction wire 221 and the feed wire 2212 at the inner side of the ring wire 2213 can extend along the same radial direction of the ring wire 2213.

In semiconductor processing, the end of the introduction wire 2211 used as the introduction end can be electrically connected to the DC power source. The DC voltage of the DC power source can be fed to the introduction wire 2211 via the introduction end. After passing the introduction wire 2211, the DC voltage can be fed to the ring wire 2213 via the end of the introduction wire 2211 electrically connected to the ring wire 2213. After the DC voltage is fed to the ring wire 2213, the DC voltage can flow along the circumference of the ring wire 2213. During the flow, the DC voltage can be fed to the plurality of feed wires 2212 arranged along the circumference of the ring wire 2213 at intervals via the ends of the plurality of feed wires 2212 electrically connected to the ring wire 2213. After the DC voltages pass through the plurality of feed wires 2212, the DC voltage can be fed to the electrode layers 232 of the plurality of absorption members 23 via the ends of the plurality of feed wires 2212 as the feed ends in a one-to-one correspondence.

With the ring wire 2213 with the opening, and by arranging the plurality of feed wires 2212 along the circumference of the ring wire 2213 at intervals, the wire structure 221 can have a separated form. That is, the wire structure 221 may not form a closed loop, which prevents the DC voltage from forming a magnetic field in the wire structure 221 to interfere with the DC voltage. Thus, the application stability of the electrostatic chuck 2 can be increased, and the semiconductor processing stability can be improved.

As shown in FIG. 6 and FIG. 7, in some embodiments, the end of the introduction wire 2211 electrically connected to the ring wire 2213 is electrically connected to an end of the ring wire 2213 with the opening.

As shown in FIG. 6 and FIG. 7, in some embodiments, an end of one feed wire 2212 of the plurality of feed wires 2212 electrically connected to the ring wire 2213 is electrically connected to the other end of the ring wire 2213 with the opening.

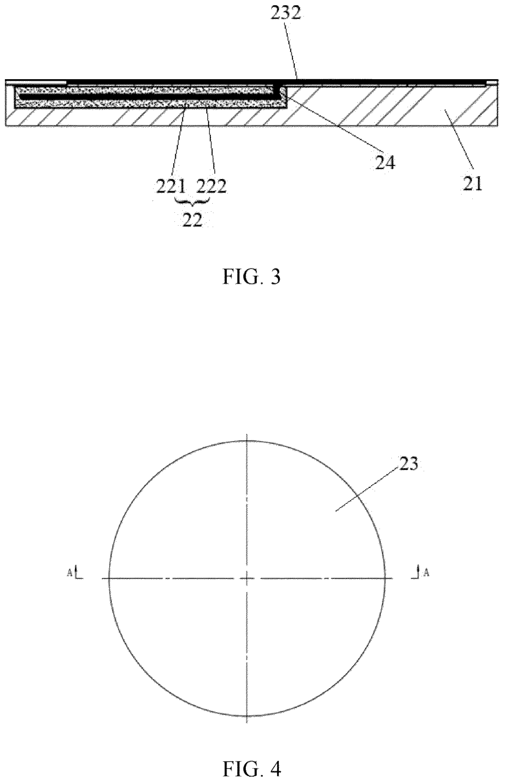

As shown in FIG. 2 and FIG. 3, in some embodiments, the voltage feed member 22 includes an insulation sleeve 222 and a plurality of elastic conductive elements 24. The insulation sleeve 222 is sleeved at the outer side of the introduction wire 2211, the plurality of feed wires 2212, and the ring wire 2213. The plurality of elastic conductive elements 24 are arranged at the plurality of feed ends in a one-to-one correspondence. The plurality of elastic conductive elements 24 can elastically and electrically contact the electrode layers of the plurality of absorption members 23.

That is, the plurality of feed ends can be electrically connected to the electrode layers 232 of the plurality of absorption members 23 through the plurality of elastic conductive elements 24 arranged at the plurality of feed ends in the one-to-one correspondence. Thus, with the elasticity of the elastic conductive elements 24, the elastic conductive elements 24 can always maintain tight electrical contact with the electrode layers 232. Thus, the plurality of feed ends can be tightly and electrically connected to the electrode layers 232 of the plurality of absorption members 23 to improve the application stability of the electrostatic chuck 2 and improve the semiconductor processing stability. Moreover, by sleeving the insulation sleeve 222 at the outer side of the introduction wire 2211, the plurality of feed wires 2212, and the ring wire 2213, the introduction wire 2211, the plurality of feed wires 2212, and the ring wire 2213 can be insulated from the chuck body 21, which prevents the RF coupled to the electrode layers 232 from interfering with the DC voltage passing through the introduction wire 2211, the plurality of feed wires 2212, and the ring wire 2213 when passing the chuck body 21. Thus, the application stability of the electrostatic chuck 2 and the semiconductor processing stability can be improved.

In some embodiments, the plurality of elastic conductive elements 24 can pass through the through-holes 234 of the plurality of absorption members 23 in the one-to-one correspondence to electrically contact the electrode layers 232 of the plurality of absorption members 23 in the one-to-one correspondence. The feed ends may not extend into the through-holes 234 of the corresponding absorption members 23.

In some embodiments, the elastic conductive element 24 can include an elastic detection pin.

As shown in FIG. 6 and FIG. 7, in some embodiments, the insulation sleeve 222 includes an introduction sleeve segment 2221, a plurality of feed sleeve segments 2222, and a ring sleeve segment 2223 with an opening. The ring sleeve segment 2223 is sleeved at the outer side of the ring wire 2213. The introduction sleeve segment 2221 and the plurality of feed sleeve segments 2222 are arranged along the circumference of the ring sleeve segment 2223 at intervals. An end of the introduction sleeve segment 2221 is communicated with the ring sleeve segment 2223. The other end is closed. The introduction sleeve segment 2221 is sleeved at the outer side of the introduction wire 2211. One end of each of the plurality of feed sleeve segments 2222 is communicated with the ring sleeve segment 2223, and the other end is closed. The plurality of feed sleeve segments 2222 are sleeved at the outer sides of the plurality of feed wires 2212 in the one-to-one correspondence.

In some embodiments, the material of the insulation sleeve 222 can include ceramic.

As shown in FIG. 1 and FIG. 8, in some embodiments, a first groove 211 and an introduction channel are arranged at the chuck body 21. The shape of the first groove 211 matches the shape of the voltage feed member 22. The voltage feed member 22 is embedded in the first groove 211. The introduction channel communicates with the first groove 211, passes through the chuck body 21, and is configured for the introduction end to be electrically connected to the DC power source.

By embedding the voltage feed member 22 into the first groove 211, the voltage feed member 22 can be positioned at the chuck body 21 with the first groove 211, which prevents the voltage feed member 22 from moving at the chuck body 21. Thus, the application stability of the electrostatic chuck 2 and the semiconductor processing stability can be improved.

As shown in FIG. 8, in some embodiments, the first groove 211 includes an introduction groove segment 2111, a plurality of feed groove segments 2112, and a ring groove segment 2113 with an opening. The ring sleeve segment 2223 and the ring wire 2213 are embedded in the introduction groove segment 2111. The introduction groove segment 2111 and the plurality of feed groove segments 2112 are arranged along the circumference of the ring groove segment 2113 at intervals. An end of the introduction groove segment 2111 communicates with the ring groove segment 2113, and the other end is closed. The introduction sleeve segment 2221 and the introduction wire 2211 are embedded in the introduction groove segment 2111. An end of each of the plurality of feed groove segments 2112 communicates with the ring groove segment 2113, and the other end is closed. The plurality of feed sleeve segments 2222 and the plurality of feed wires 2212 are embedded in the plurality of feed groove segments 2112 in a one-to-one correspondence. The introduction channel communicates with the introduction groove segment 2111 and passes through the chuck body 21 for the introduction end to be electrically connected to the DC power source.

As shown in FIG. 8, in some embodiments, a plurality of second grooves 212 are arranged at the chuck body 21 at intervals. The plurality of second grooves 212 communicate with a part of the first groove 211 with the embedded feed end. The shape of the second groove 212 matches the shape of the absorption member 23. The plurality of absorption members 23 are arranged at the plurality of second grooves 212 in a one-to-one correspondence. Thus, the feed groove segments 2112 of the first groove 211 can extend into the corresponding second grooves 212. That is, the parts of the first grooves 211 extending into the second grooves 212 can be groove segments formed at the bottom of the second grooves 212. Thus, the feed sleeve segments 2222 and the feed wires 2212 can extend to the bottom of the absorption members 23 in the second grooves 212 and can be electrically connected to the electrode layers 232 via the through-holes 234. In some embodiments, the feed groove segments 2112 of the first grooves 211 can extend to the center position of the second grooves 212 where the ends of the corresponding second grooves 212 are located. In addition, by arranging the plurality of absorption members 23 in the plurality of second grooves 212 in the one-to-one correspondence, the plurality of absorption members 23 can be positioned at the chuck body 21 with the plurality of second grooves 212, which prevents the absorption members 23 from moving at the chuck body 21. Thus, the application stability of the electrostatic chuck 2 and the semiconductor processing stability can be improved.

As shown in FIG. 1 and FIG. 8, in some embodiments, the plurality of second grooves 212 are arranged at the chuck body 21 at uniform intervals. Thus, the plurality of absorption members 23 can be arranged at the chuck body 21 at uniform intervals.

In some embodiments, the absorption members 23 can be adhered to the second grooves 212. That is, the absorption members 23 can be connected to the chuck body 21 in the adhesion method.

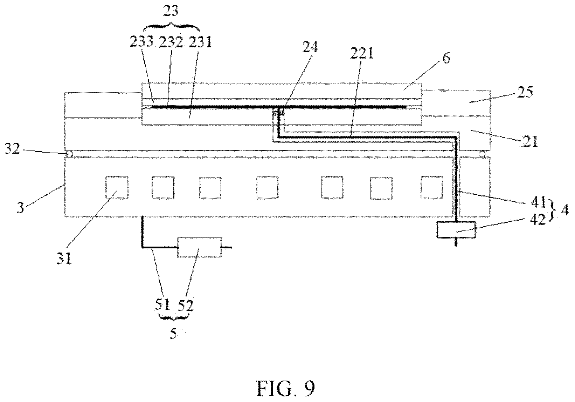

As shown in FIG. 9, embodiments of the present disclosure further provide a base, including a chuck 3 and an electrostatic chuck 2 of embodiments of the present disclosure. The electrostatic chuck 2 is arranged on the chuck 2 and configured to absorb the plurality of wafers 6.

In the base of embodiments of the present disclosure, by arranging the electrostatic chuck 2 of embodiments of the present disclosure on the chuck 3, the electrostatic chuck 2 of embodiments of the present disclosure can be configured to absorb the plurality of wafers 6 to reduce the manufacturing difficulty and cost of the multi-wafer electrostatic chuck 2. Moreover, the RF coupling efficiency and the semiconductor processing efficiency can be improved.

As shown in FIG. 9, in some embodiments, the base further includes an electrical feed assembly 4 and an RF feed assembly 5. The electrical feed assembly 4 is electrically connected to the voltage feed member 22. The electrical feed assembly 4 can be configured to be electrically connected to the DC power source to feed the DC voltage of the DC power source to the voltage feed member 22. The RF feed assembly 5 is electrically connected to the chuck 3 and configured to feed the RF to the electrostatic chuck 2 through the chuck 3.

As shown in FIG. 9, in some embodiments, the electrical feed assembly 4 includes an electrical feed wire 41 and a filter 42. The RF feed assembly 5 includes an RF feed wire 51 and a match 52. The match 52 can be configured to be electrically connected to the RF source (not shown in the figure). The RF feed wire 51 can be electrically connected to the match 52 and the chuck 3. The filter 42 can be configured to be electrically connected to the DC power source (not shown in the figure). The electrical feed wire 41 passes through the chuck 3 and is electrically connected to the filter 42 and the introduction wire 2211. In the semiconductor processing, the RF source can provide RF. The RF provided by the RF source can be fed to the chuck 3 through the match 52. Then, the RF can be coupled to the electrode layer 232 of the absorption member 23 through the chuck 3, the chuck body 21, and the insulation layer 231 of the absorption member 23. The DC power source can provide the DC voltage. The DC voltage can be fed to the electrode layer 232 of the absorption member 23 through the filter 42, the electrical feed wire 41, the introduction wire 2211, the ring wire 2213, the feed wire 2212, and the elastic conductive element 24.

As shown in FIG. 9, in some embodiments, a cooling channel 31 configured to allow a coolant to flow through is arranged at the chuck 3. Thus, the electrostatic chuck 2 can be cooled through the coolant.

As shown in FIG. 9, in some embodiments, a sealing ring 32 is arranged between the electrostatic chuck 2 and the chuck 3 to allow an inert gas to be introduced. The electrostatic chuck 2 and the chuck 3 can be sealed by the sealing ring 32 and the inert gas.

In some embodiments, the inert gas can include helium.

In summary, with the electrostatic chuck 2 and the base of embodiments of the present disclosure, the manufacturing difficulty and the cost of the multi-wafer electrostatic chuck 2 can be reduced, and the RF coupling efficiency and the semiconductor processing efficiency can be improved.

The above embodiments are exemplary embodiments of the present disclosure to describe the principle of the present disclosure. However, the present disclosure is not limited to this. For those skilled in the art, various variations and improvements can be made without departing from the spirit and essence of the present disclosure. These variations and improvements are within the scope of the present disclosure.

## Claims

1. An electrostatic chuck configured to absorb a plurality of wafers comprising a chuck body, a voltage feed member, and a plurality of absorption members, wherein:
the plurality of adsorption members are arranged at the chuck body at intervals, and each absorption member of the plurality of absorption members includes an insulation layer, an electrode layer, and a dielectric layer arranged sequentially in a direction away from the chuck body; and
the voltage feed member is arranged between the adsorption members and the chuck body and is electrically connected to electrode layers of the plurality of adsorption members, and the voltage feed member is configured to feed direct current (DC) voltage into the electrode layer of each adsorption member of the plurality of absorption members to allow the plurality of absorption members to absorb the plurality of wafers in a one-to-one correspondence.

2. The electrostatic chuck according to claim 1, further comprising a positioning member, the positioning member being arranged at the chuck body and including a plurality of positioning through-holes arranged at intervals, and the plurality of absorption members being arranged in the plurality of positioning through-holes in a one-to-one correspondence.

3. The electrostatic chuck according to claim 1 or claim 2, wherein through-holes are formed at the insulation layers of the absorption members, the through-holes pass through the insulation layers to the electrode layers, the voltage feed member includes a wire structure, the wire structure includes an introduction end and a feed end, the introduction end is configured to be electrically connected to the DC power source, a quantity of feed ends is same as a quantity of the absorption members, the feed ends are electrically connected to the electrode layers via the through-holes.

4. The electrostatic chuck according to claim 3, wherein the wire structure includes an introduction wire, a plurality of feed wires, and a ring-shaped wire with an opening, one end of the introduction wire is electrically connected to the ring-shaped wire, the other end of the introduction wire is used as the introduction end, the plurality of feed wires are arranged along a circumference of the ring-shaped wire at intervals, one end of each feed wire of the plurality of feed wires is electrically connected to the ring-shaped wire, and the other end of each feed wire of the plurality of feed wires are used as the feed end.

5. The electrostatic chuck according to claim 4, wherein the voltage feed member further includes an insulation sleeve and a plurality of elastic conductive elements, the insulation sleeve is sleeved at an outer side of the introduction wire, the plurality of feed wires, and the ring-shaped wire, the plurality of elastic conductive elements are arranged at the plurality of feed ends in a one-to-one correspondence, and the plurality of elastic conductive elements electrically contact the electrode layers of the plurality of absorption members in a one-to-one correspondence.

6. The electrostatic chuck according to claim 3, wherein the chuck body includes a first groove and an introduction channel, a shape of the first groove matches a shape of the voltage feed member, the voltage feed member is embedded in the first groove, and the introduction channel communicates with the first groove, passes through the chuck body, and is configured for the introduction end to be electrically connected to the DC power source.

7. The electrostatic chuck according to claim 6, wherein the chuck body includes a plurality of second grooves arranged at intervals, the plurality of second grooves communicate with a part of the first groove embedded with the feed end, shapes of the second grooves match shapes of the absorption members, and the plurality of absorption members are arranged in the plurality of second grooves in a one-to-one correspondence.

8. The electrostatic chuck according to claim 7, wherein the adsorption members are adhered to the second grooves.

9. The electrostatic chuck according to claim 1, wherein a thickness of the insulation layer is greater than or equal to 0.6 mm and smaller than or equal to 0.8 mm, a thickness of the electrode layer is greater than or equal to 0.03 mm and smaller than or equal to 0.04 mm, and a thickness of the dielectric layer is greater than or equal to 0.25 mm and smaller than or equal to 0.35 mm.

10. The electrostatic chuck according to claim 1, wherein a material of the insulation layer includes ceramic, and a material of the chuck body includes metal.

11. A base comprising a chuck and the electrostatic chuck according to any one of claims 1 to 10, wherein the electrostatic chuck is arranged on the chuck and configured to absorb the plurality of wafers.

12. The base according to claim 11, further comprising a electrical feed assembly and an RF feed assembly, the electrical feed assembly being electrically connected to the voltage feed member, the electrical feed assembly being configured to be electrically connected to the DC power source and feed the DC voltage provided by the DC power source to the voltage feed member, and the RF feed assembly being electrically connected to the chuck and configured to feed RF to the electrostatic chuck through the chuck.
